# EUROPÄISCHE PATENTANMELDUNG

(11) **EP 1 770 564 A1**
(43) Veröffentlichungstag der Anmeldung: **04.04.2007**
(21) Anmeldenummer: 05109040.5
(22) Anmeldetag: 29.09.2005
(51) Int. Cl.: G06F 17/50

(54) **Entwurf einer elektronischen Schaltung**

(71) Anmelder: Knipping, Uwe, D-85598 Baldham (DE)
(72) Erfinder: Knipping, Uwe, D-85598 Baldham (DE)
(74) Vertreter: Schneider, Günther Martin

(57) **Zusammenfassung**

Verfahren zum Entwurf einer elektronischen Schaltung mit mindestens zwei Bauelementen auf einer Baugruppe, von denen zumindest eines ein feldprogrammierbares Bauelement, FPGA, ist, das zur Realisierung zumindest eines Teiles der elektronischen Schaltung bestimmt ist, wobei das zumindest eine FPGA eine vorbestimmte Anzahl von Anschlusspins aufweist, über welche es elektrisch mit anderen Bauelementen verbindbar ist, wobei auf der Baugruppe elektrische Verbindungen zwischen den zur Realisierung der elektronischen Schaltung benötigten Anschlusspins des zumindest einen FPGA und dem zumindest einen Bauelement entworfen werden, dadurch gekennzeichnet, dass auf der Baugruppe zusätzliche elektrische Verbindungen zwischen zumindest einem Teil der zur Realisierung der elektronischen Schaltung nicht benötigten Anschlusspins des zumindest einen FPGA und zumindest einem weiteren Bauelement entworfen werden.

## Beschreibung

Die vorliegende Erfindung betrifft den Entwurf elektronischer Schaltungen unter Verwendung von digitalen feldprogrammierbaren Bausteinen (field programmable gate array, abgekürzt FPGA).

Komplexe elektronische Schaltungen werden heutzutage in Form integrierter Schaltkreise realisiert, insbesondere in anwendungsspezifischen integrierten Schaltkreisen (application specific integrated circuits, abgekürzt ASICs). Diese Bausteine sind in der Regel verhältnismäßig teuer und benötigen viel Zeit in der Herstellung. Des Weiteren können sie nur schwierig und kostenintensiv geändert werden. Aus diesem Grund wird die Funktion des integrierten Schaltkreises zunächst auf einer Baugruppe mit FPGAs realisiert. FPGAs werden auch eingesetzt, wenn die Herstellung eines ASIC zu teuer ist oder nur Kleinserien benötigt werden. FPGAs sind Bauelemente, deren interne Logik von außen programmierbar ist. FPGAs erlauben es, die interne Funktionalität und damit das Verhalten der Schaltung durch Umprogrammierung grundsätzlich beliebig oft zu ändern. Dies ist in der Regel notwendig zur Beseitigung von Fehlern oder zur Erweiterung der Funktionalität der Schaltung.

Zwar lässt sich die Funktion einer integrierten Schaltung bereits mit einem einzigen FPGA realisieren, in praktisch relevanten Fällen sind hierzu mehrere FPGAs vonnöten, denn ein FPGA hat in der Regel nicht die Komplexität eines ASIC. Dann wird die Schaltungsbeschreibung (Netzliste) des integrierten Schaltkreises auf mehrere FPGAs verteilt, und die FPGAs werden auf einer Leiterplatte gemäß der Verteilung der Schaltungsbeschreibung miteinander verbunden. Dies geschieht zumeist mittels einer Software, auch als Partitionierungssoftware bezeichnet, die eine neue Schaltungsbeschreibung (Teilnetzlisten) für die Realisierung mit FPGAs generiert. Z.B. kann eine Schaltung mit 2 Millionen Gatter auf 5 FPGAs zu je 400.000 Gatter aufgeteilt werden. Für die Verbindungen zwischen den einzelnen FPGAs und den weiteren Bauelementen stehen je nach Leiterplattentechnologie mehrere Leiterebenen zur Verfügung.

Zur elektrischen Verbindung der internen Gatter mit anderen Bauelementen haben die FPGAs eine gewisse Anzahl elektrischer Anschlüsse (Anschlusspins). In den meisten Fällen werden beim ersten Entwurf der elektronischen Schaltung nicht alle Anschlüsse der einzelnen FPGAs verwendet, weil die Partitionierungssoftware die Anzahl der verfügbaren Pins der FPGAs keinesfalls überschreiten darf, in den meisten Fällen aber mit weniger auskommt.

Eine Realisierung der Baugruppe mit der einmal generierten Schaltungsbeschreibung (Netzliste) schränkt aber die Flexibilität für Änderungen stark ein, wenn später aufgrund von Änderungen des Schaltungsentwurfs mehr Verbindungen zwischen den FPGAs oder darüber hinaus zusätzliche Bauelemente wie z.B. Stecker zum Anschluss von Messgeräten wie Logik-Analysatoren benötigt werden. In besonders ungünstig gelagerten Fällen kann dies sogar dazu führen, dass die einmal entworfene Baugruppe für eine Designänderung nicht mehr nutzbar ist, obwohl die eingesetzten FPGAs noch freie Anschlusspins haben, die genutzt werden könnten.

Bei Verwendung herkömmlicher Partitionierungssoftware kann die Nutzbarmachung bislang ungenutzter Anschlusspins nur individuell für jedes FPGA der Baugruppe erfolgen. Hierzu sind jeweils die folgenden Schritte notwendig:
- Generieren von grafischen Symbolen für die FPGAs zur Beschreibung der Baugruppe;
- Erweitern der grafischen Symbole für zusätzliche Verbindungen;
- Aufrufen der neuen grafischen Symbole und Platzieren derselben auf der grafischen Oberfläche; und
- Erstellen der zusätzlichen Verbindungen.

Das grafische Symbol ist also notwendig, um mit Hilfe einer weiteren Software (Schematic Entry), die zur grafischen Eingabe von Baugruppen dient, die zusätzlichen Verbindungen herzustellen.

Aufgabe der Erfindung ist es, die beim Entwurf zunächst ungenutzten Anschlusspins von FPGAs einer Baugruppe für spätere Änderungen der implementierten Schaltung nutzbar zu machen.

Erfindungsgemäß wird diese Aufgabe wird durch das Verfahren gemäß den Ansprüchen gelöst.

Erfindungsgemäß bereitgestellt wird also ein Verfahren zum Entwurf einer elektronischen Schaltung mit mindestens zwei Bauelementen auf einer Baugruppe, von denen zumindest eines ein feldprogrammierbares Bauelement, FPGA, ist, das zur Realisierung zumindest eines Teiles der elektronischen Schaltung bestimmt ist, wobei das zumindest eine FPGA eine vorbestimmte Anzahl von Anschlusspins aufweist, über welche es elektrisch mit anderen Bauelementen verbindbar ist, wobei auf der Baugruppe elektrische Verbindungen zwischen den zur Realisierung der elektronischen Schaltung benötigten Anschlusspins des zumindest einen FPGA und dem zumindest einen Bauelement entworfen werden, dadurch gekennzeichnet, dass auf der Baugruppe zusätzliche elektrische Verbindungen zwischen zumindest einem Teil der zur Realisierung der elektronischen Schaltung nicht benötigten Anschlusspins des zumindest einen FPGA und zumindest einem weiteren Bauelement entworfen werden.

In einer weiteren Ausgestaltung der Erfindung wird auf der Baugruppe Platz für zumindest ein weiteres Bauelement vorgesehen, welches für die Realisierung der elektronischen Schaltung nicht benötigt wird, und wobei zusätzliche Verbindungen zwischen dem zumindest einen FPGA und dem zumindest einen weiteren Bauelement entworfen werden.

Zumindest ein weiteres Bauelement kann eine Anschlussvorrichtung sein.

Die Verbindungen können zumindest teilweise als leitende Bahnen auf der Baugruppe realisiert werden.

Zusätzliche Verbindungen können zwischen jedem Paar und/oder weiteren Kombinationen von FPGAs vorgesehen werden.

Die Baugruppe kann einen Schaltungsträger, insbesondere eine Leiterplatte, umfassen

Der in dem zumindest einen FPGA realisierte Teil der elektronischen Schaltung kann zur späteren Realisierung in zumindest einem anwendungsspezifischen integrierten Schaltkreis bestimmt sein.

Die elektronische Schaltung, der Schaltungsteil und die Verbindungen können jeweils durch Netzlisten repräsentiert werden.

Die Netzlisten können durch Aufteilen, insbesondere Partitionieren der elektronischen Schaltung erzeugt werden.

Die Anzahl der zusätzlichen Verbindungen und/oder der zusätzlichen Bauelemente können durch einen Benutzer vorgebbar sein.

In einer weiteren Ausgestaltung der Erfindung wird auf der Basis der jeweiligen Netzlisten die Anzahl der zur Realisierung der elektronischen Schaltung benötigten Anschlusspins der Bauelemente ermittelt und hieraus dem Benutzer eine Anzahl der nicht benötigten Anschlusspins vorgegeben, zu denen zusätzliche elektrische Verbindungen entworfen werden.

Auf der Basis der Netzlisten kann bestimmt werden, welche zusätzlichen Verbindungen und weiteren Bauelemente auf der Baugruppe vorgesehen werden.

Basierend auf der Schaltungsbeschreibung (Netzliste) und den eingesetzten FPGAs wird also bereits beim ersten Entwurf eine Erweiterung für die Baugruppe vorgenommen, die für spätere Designänderungen nutzbar gemacht werden kann. Die einmal entworfene Baugruppe kann also für diese Designänderungen weiterverwendet werden.

Die Erfindung wird anhand der Zeichnung näher beschrieben. In der Zeichnung zeigen:
- Fig. 1: ein FPGA mit der Anzahl von Anschlusspins P,
- Fig. 2: eine geplante Baugruppe mit einem ASIC und vier weiteren Bauelementen,
- Fig. 3: die Realisierung der Baugruppe unter Verwendung von FPGAs,
- Fig. 4: einen Ausschnitt aus Fig. 3 mit Darstellung der ungenutzten Ressourcen,
- Fig. 5: eine Erweiterung durch zusätzliche Verbindungen und
- Fig. 6: eine Erweiterung durch zusätzliche Bauelemente und zusätzliche Verbindungen.

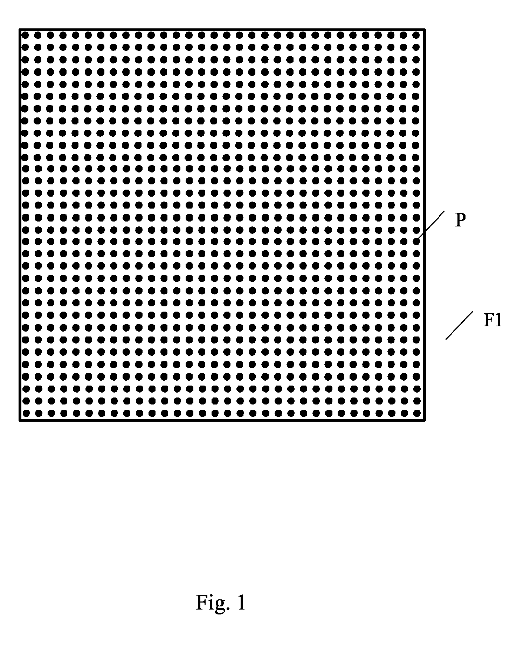

Fig. 1 zeigt ein FPGA F1 mit den Anschlusspins P am Beispiel eines Ball-Grid-Array-Gehäuses. Die Anschlusspins P sind mit den internen Gattern verbunden und dienen extern zur elektrischen Verbindung mit anderen Bauelementen.

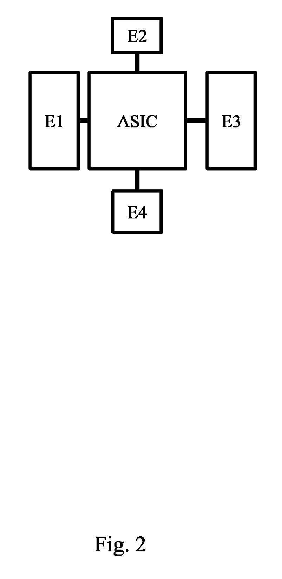

Die in Fig. 2 illustrierte Baugruppe umfasst einen ASIC sowie vier weitere Bauelemente E1-E4. Im Zusammenspiel mit diesen weiteren Bauelementen wird das ASIC in eine Funktionseinheit integriert. Z.B. wird ein ASIC für ein mobiles Telefon erst dann funktionsfähig, wenn als zusätzliche Bauelemente wie Hochfrequenzteil mit Antenne, Mikrofon, Lautsprecher, Tastaturblock und Display mit auf die Baugruppe integriert sind.

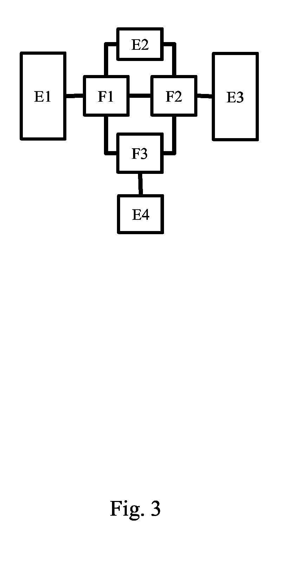

Gemäß Fig. 3 wird die Funktion des ASIC nun durch eine Zusammenschaltung dreier FPGAs F1-F3 realisiert. Im Rahmen des Schaltungsentwurfes wird also der auf den ASIC entfallende Schaltungsteil (ASIC-Netzliste) auf die drei FPGAs F1-F3 verteilt. Die hierzu verwendete Partitionierungssoftware liefert vier Netzlisten, und zwar drei für die interne Programmierung der einzelnen FPGAs F1-F3 und eine für deren Zusammenschaltung. Die letztere Netzliste kann die Komponenten E1 bis E4 ebenfalls enthalten, wenn diese in der Netzliste für die Partitionierungssoftware enthalten waren und hier entsprechend gekennzeichnet wurden. Ansonsten wird die Netzliste mit F1-F3 und E1-E4 auf anderen, bekannten Wegen generiert. Die Zusammenschaltung erfolgt durch Verbindungen V zwischen den Anschlusspins der jeweiligen FPGAs und der übrigen Bauelemente. Die benötigten Verbindungen V sind durch durchgezogene Linien illustriert. Zusammengeschaltet haben die drei FPGAs dann die gleiche Funktion wie das ASIC 10 gemäß Fig. 2.

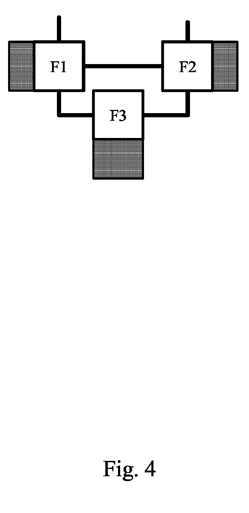

In den meisten Fällen werden beim ersten Entwurf mit FPGAs, wie oben bereits erwähnt, nicht alle verfügbaren Anschlusspins der FPGAs zur Realisierung der zunächst vorgesehenen Funktion benötigt. In Fig. 4 sind die nicht benötigten Anschlusspins der FPGAs F1, F2, F3 durch schraffierte Flächen angedeutet. Spätere Änderungen der zu realisierenden Funktion können zusätzliche Verbindungen z.B. zwischen F1 und F2 notwendig machen. Diese würden nicht zur Verfügung stehen, wenn die Baugruppe inklusive der Verbindungen aufgrund der Partitionierung (und der Netzlisten) des ersten Entwurfs realisiert wird. Denn zusätzliche Verbindungen auf einer bestehenden Baugruppe sind überhaupt nicht oder nur mit technisch hohem Aufwand zu realisieren.

Erfindungsgemäß erfolgt die Erweiterung nicht wie bisher auf Bausteinebene, sondern auf Baugruppenebene.

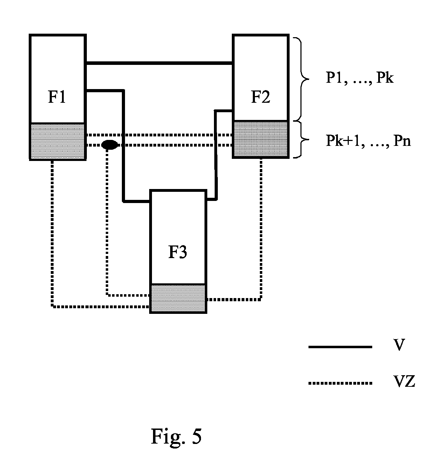

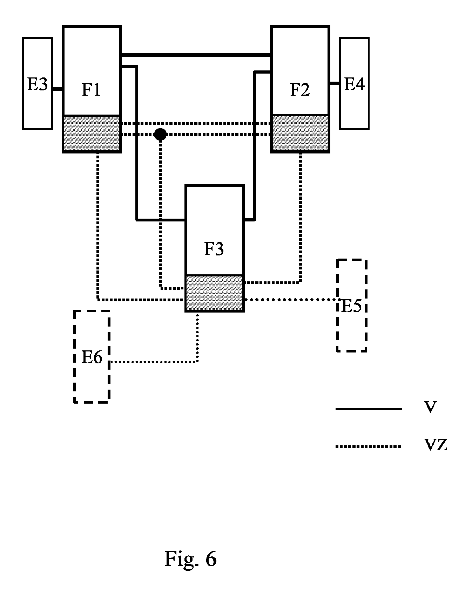

Hierbei werden die Anzahl der gewünschten Verbindungen und/oder die zusätzlichen Bauelemente angegeben, die Erweiterung der einzelnen Bausteine erfolgt dann automatisch. Damit werden mehrere der eingangs beschriebenen manuellen Schritte, die zu Fehlern führen können, vereinfacht und sicherer gemacht. Die Implementierung der Erweiterung ist in Fig. 5 und 6 illustriert. Hierbei werden Verbindungen zwischen den FPGAs für eine spätere Logikänderung bereits im ersten Entwurf mit den FPGAs vorgesehen.

Die zusätzlichen Bauelemente mit den entsprechenden Verbindungen (VZ) können z.B. Kontaktleisten sein, an denen Messinstrumente angeschlossen werden können. In Fig. 5 sind lediglich zusätzliche Verbindungen VZ zwischen den bereits benutzten Bauelementen F1, F2, F3 illustriert, und in Fig. 6 sind auch zusätzliche Bauelemente E5, E6 mit den entsprechenden zusätzlichen Verbindungen VZ dargestellt. Die Reihenfolge ist bei der Realisierung jedoch unerheblich.

Die zusätzlichen Verbindungen VZ bzw. die zusätzlichen Bauelemente berühren die ursprüngliche Netzliste (und somit die Funktionalität der gemäß dem Entwurf realisierten Schaltung) nicht, sie werden aber auf der Baugruppe bereits realisiert. Damit stehen Verbindungen und Plätze für Bauelemente zur Verfügung, die später genutzt werden können. Im obigen Beispiel können zwischen allen Bauelementen zusätzliche Verbindungen vorgesehen werden, wodurch eine Designänderung sehr vereinfacht wird. Diese Designänderung kann sich dann auf eine Umprogrammierung der FPGAs und dem Einsetzen der etwaigen zusätzlichen Bauelemente in die bereits entworfene Baugruppe reduzieren.

Die Erfindung lässt sich besonders vorteilhaft in einem rechnergestützten Schaltungsentwurfssystem einsetzen. Hierin erfolgt zunächst die Partitionierung der Netzliste, also die Verteilung der Schaltung auf die einzelnen FPGAs. Es wird die Netzliste der zu realisierenden Baugruppe eingelesen und die Implementierung der Instanzen festgelegt. Hiermit steht fest, wie viele Anschlusspins aufgrund der Netzliste benötigt werden und wie viele Anschlusspins als freie Ressourcen zur Verfügung stehen (Fig. 4). Die Erfindung ermöglicht es, beim ersten Entwurf diese freien Ressourcen durch zusätzliche Verbindungen auf Baugruppenebene in die Schaltung einzubinden, um sie für spätere Erweiterungen nutzbar zu machen (Fig. 5). Des Weiteren besteht die Möglichkeit, zusätzliche Bauelemente (E5 in Fig. 6) wie Stecker zum Anschluss eines Logik-Analysators mit einzufügen. Diese können später zur Fehlersuche im Design benutzt werden. Ein Vorteil dieser Erfindung besteht darin, die Baugruppe früher herstellen und nutzen zu können, da spätere Änderungen oder Erweiterungen der Logik innerhalb der FPGAs oder weitere Erfordernisse wie Messleisten vorab berücksichtigt werden können, indem entsprechende Ressourcen hierfür auf der Baugruppe integriert werden.

Die erfindungsgemäße Erweiterung der Baugruppe mit zusätzlichen Verbindungen und für zusätzliche Bauelemente erfolgt mit Hilfe einer Software. Hierbei wird die Beschreibung der zu implementierenden Schaltung (Netzliste) und die Zuordnung von physikalischen Bauteilen vorgenommen. In Fig. 4 ist eine Zuordnung von F1-F3 so getroffen worden, dass programmierbare Bausteine mit mehr Anschlüssen als notwendig eingesetzt werden. Basierend auf den Daten stellt die Software nun dem Anwender die Information über freie Anschlüsse für jeden programmierbaren Baustein und eine Eingabemöglichkeit zur Verfügung, die zusätzlichen Bauelemente und Verbindungen auf sehr einfache und übersichtliche Form einzugeben. Die Erweiterung der Bausteinbeschreibung und die Implementierung der zusätzlichen Verbindungen auf der Baugruppe geschehen automatisch.

Die Eingabe der zusätzlichen Bauelemente kann vorteilhafterweise z.B. durch eine Auswahlliste erfolgen. Hierbei kann der Benutzer entscheiden, welche Bauelemente wie z.B. Messleisten er benötigt. Die erforderliche Anzahl kann sich automatisch aus der benötigten Anzahl der Verbindungen ergeben. Als Beispiel werden drei Messleisten eingefügt, wenn diese 20 Anschlüsse haben und 50 Verbindungen benötigt werden. Die Erweiterung der zusätzlichen Verbindungen kann z.B. über eine Tabelle erfolgen. In den Zeilen werden neue Netze definiert, in den Spalten stehen die FPGAs und alle weiteren Komponenten. An den Kreuzungspunkten sind Auswahlboxen. Wenn man dort ein Häkchen erzeugt, wird die Verbindung hergestellt, ansonsten nicht. Damit können Verbindungen zwischen den FPGAs und/oder zu den Messpunkten erfolgen. Diese werden in der erweiterten Netzliste mit eingebracht.

Mit der Erfindung werden Fehler vermieden und eine konsistente Datenbasis erzielt.

Die Erfindung umgeht die aufwendige Prozedur über die Schematic Entry und erlaubt es, die gewünschte Erweiterung sowohl auf der logischen Ebene als auch für die Baugruppe auf sehr einfache und übersichtliche Weise zu implementieren. Fehler werden damit vermieden.

## Patentansprüche

1. Verfahren zum Entwurf einer elektronischen Schaltung mit mindestens zwei Bauelementen (F1, F2, F3, ..., E5, E6) auf einer Baugruppe (L), von denen zumindest eines (F1, F2, F3) ein feldprogrammierbares Bauelement, FPGA, ist, das zur Realisierung zumindest eines Teiles der elektronischen Schaltung bestimmt ist,
wobei das zumindest eine FPGA (F1, F2, F3) eine vorbestimmte Anzahl von Anschlusspins (P1, ..., Pn) aufweist, über welche es elektrisch mit anderen Bauelementen verbindbar ist,
wobei auf der Baugruppe (L) elektrische Verbindungen (V) zwischen den zur Realisierung der elektronischen Schaltung benötigten Anschlusspins (P1, ..., Pk) des zumindest einen FPGA (F1, F2, F3) und dem zumindest einen Bauelement (F1, F2, F3, ..., E5, E6) entworfen werden,
**dadurch gekennzeichnet,**
**dass** auf der Baugruppe (L) zusätzliche elektrische Verbindungen (VZ) zwischen zumindest einem Teil der zur Realisierung der elektronischen Schaltung nicht benötigten Anschlusspins (Pk+1, ..., Pn) des zumindest einen FPGA (F1, F2, F3) und zumindest einem weiteren Bauelement (E1, E2, ..., F1, F2, F3) entworfen werden.

2. Verfahren gemäß Anspruch 1, wobei auf der Baugruppe (L) Platz für zumindest ein weiteres Bauelement (E5, E6) vorgesehen wird, welches für die Realisierung der elektronischen Schaltung nicht benötigt wird, und wobei zusätzliche Verbindungen zwischen dem zumindest einen FPGA (F1, F2, F3) und dem zumindest einen weiteren Bauelement (E5, E6) entworfen werden.

3. Verfahren gemäß Anspruch 1 oder 2, wobei zumindest ein weiteres Bauelement eine Anschlussvorrichtung (SL) ist.

4. Verfahren gemäß einem der vorherigen Ansprüche, wobei die Verbindungen (V, VZ) zumindest teilweise als leitende Bahnen auf der Baugruppe (L) realisiert werden.

5. Verfahren gemäß einem der vorherigen Ansprüche, wobei zusätzliche Verbindungen (VZ) zwischen jedem Paar (F1, F2; F1, F3; F2, F3) und/oder weiteren Kombinationen von FPGAs (F1, F2, F3) vorgesehen werden.

6. Verfahren gemäß einem der vorherigen Ansprüche, wobei die Baugruppe (L) einen Schaltungsträger, insbesondere eine Leiterplatte, umfasst.

7. Verfahren gemäß einem der vorherigen Ansprüche, wobei der in dem zumindest einen FPGA (F1, F2, F3) realisierte Teil der elektronischen Schaltung zur späteren Realisierung in zumindest einem anwendungsspezifischen integrierten Schaltkreis bestimmt ist.

8. Verfahren gemäß einem der vorherigen Ansprüche, wobei die elektronische Schaltung, der Schaltungsteil und die Verbindungen (V, VZ) jeweils durch Netzlisten repräsentiert werden.

9. Verfahren gemäß einem der vorherigen Ansprüche, wobei die Netzlisten durch Aufteilen, insbesondere Partitionieren der elektronischen Schaltung erzeugt werden.

10. Verfahren gemäß einem der vorherigen Ansprüche, wobei die Anzahl der zusätzlichen Verbindungen (VZ) und/oder der zusätzlichen Bauelemente (E5, E6) durch einen Benutzer vorgebbar ist.

11. Verfahren gemäß einem der Ansprüche 8 bis 10, wobei auf der Basis der jeweiligen Netzlisten die Anzahl der zur Realisierung der elektronischen Schaltung benötigten Anschlusspins (P1, ..., Pk) der Bauelemente ermittelt wird und hieraus dem Benutzer eine Anzahl der nicht benötigten Anschlusspins (Pk+1, ..., Pn) vorgegeben wird, zu denen zusätzlichen elektrischen Verbindungen (VZ) entworfen werden.

12. Verfahren gemäß einem der Ansprüche 8 bis 11, wobei auf der Basis der Netzlisten bestimmt wird, welche zusätzlichen Verbindungen (VZ) und weiteren Bauelemente (E5, E6) auf der Baugruppe (L) vorgesehen werden.
